# EUROPÄISCHE PATENTANMELDUNG

(11) **EP 0 853 447 A2**
(43) Veröffentlichungstag der Anmeldung: **15.07.1998**
(21) Anmeldenummer: 98100327.0
(22) Anmeldetag: 10.01.1998
(51) Int. Cl.: H05K 5/00, H05K 7/14

(54) **Gehäuse für elektronische Beauteile**

(30) Priorität: 10.01.1997 DE 19700558
(71) Anmelder: Fischer-Elektronik GmbH & Co. KG., 58511 Lüdenscheid (DE)
(72) Erfinder: Kampe, Lothar, 58511 Lüdenscheid (DE)
(74) Vertreter: Hassler, Werner, Dr.

(57) **Zusammenfassung**

Ein Gehäuse für elektronische Bauteile mit zwei rinnenförmigen Halbschalen, deren an einer Längsseite sitzende Stege mit einer Aufnahmerinne und einer Leiste paarig zueinander passen und Schraubkanäle aufweisen, und mit einer in die Schraubkanäle der Halbschalen eingreifenden und dieselben zusammenhaltenden Stirnplatte. Das technische Problem ist die Sicherung des Gehäuses nach Festziehen der Schraubverbindungen ohne zusätzliche Verbindungsmittel. Die Seitenwände der Aufnahmerinne (7) und der Leiste (8) sind jeweils unter spitzen Winkel zu der Längsseite (2) der Halbschalen ausgerichtet.

## Beschreibung

Die Erfindung betrifft ein Gehäuse für elektronische Bauteile mit zwei rinnenförmigen Halbschalen, deren an einer Längsseite sitzende Stege mit einer Aufnahmerinne und einer Leiste paarig zueinander passen und Schraubkanäle aufweisen, und mit einer in die Schraubkanäle der Halbschalen eingreifenden und dieselben zusammenhaltenden Stirnplatte.

Derartige Gehäuse finden im Bereich von Verbindungsleitungen zwischen EDV-Geräten Anwendung und nehmen elektronische Baugruppen wie Adapterstufen. Interfaceschaltungen. Codierschaltungen, Schnittstellen und dergleichen auf. Die Halbschalen des Gehäuses lassen sich paarig zusammenfügen und werden durch die Stirnplatten zusammengehalten. Es sind allerdings Schwenkbewegungen der Halbschalen um die Achsen der Schraubverbindungen möglich, so daß kein vollständiger Abschluß des Gehäuses sichergestellt ist.

Aufgabe der Erfindung ist die Sicherung des Gehäuses nach Festziehen der Schraubverbindungen ohne zusätzliche Verbindungsmittel.

Diese Aufgabe wird nach der Erfindung dadurch gelöst, daß die Seitenwände der Aufnahmerinne und der Leiste jeweils unter einem spitzen Winkel zu der Längsseite der Halbschalen ausgerichtet sind.

Die Erfindung unterscheidet sich insofern vom Stand der Technik, als durch Neigung der Aufnahmerinne gegenüber der Ebene der Längswand die Bewegungen des Zusammenfügens der Halbschalen und der Schwenkung um die Achsen der Schraubverbindungen entkoppelt sind. Die Bewegung des Zusammenfügens erfolgt in einer Richtung geneigt zur Längswand, und die Schwenkung bewirkt im Bereich der Aufnahmerinne eine Bewegung im wesentlichen in einer Richtung senkrecht zur Längswand.

Eine sichere Sperrung des Gehäuses wird dadurch erzielt, daß die Neigung der Seitenwände der Aufnahmerinne mindestens 20° beträgt.

Eine vollständige Entkopplung der Bewegungen erreicht man dadurch, daß die Seitenwände der Aufnahmerinne nach der Außenseite des Steges geneigt sind.

Eine einfache Ausbildung der Führungen wird dadurch erzielt, daß die Aufnahmerinne und die Leiste einen rechteckigen Querschnitt haben

Ein Ausführungsbeispiel der Erfindung wird anhand der Zeichnung erläutert, in der darstellen:
Fig. 1 ein aus zwei Halbschalen zusammengesetztes Gehäuse,
Fig. 2 eine zugehörige Abdeckplatte und
Fig. 3 eine Verbindungsfuge der Halbschalen in vergrößerter Darstellung.

Das Gehäuse umfaßt zwei gleiche, rinnenförmige Halbschalen 1, die jeweils eine Längswand 2 und zwei senkrecht abstehende Stege 3,4 umfassen. Die Stege 3 und 4 der beiden Halbschalen 1 passen jeweils paarig zusammen. An dem Steg 4 ist ein Schraubkanal 5 angeformt, der einen parallel zur Ebene der Längswand 2 offenen Schlitz 6 aufweist. In die einander gegenüberstehenden Schlitze 6 kann eine Leiterplatte 11 oder eine Montageplatte eingeschoben werden.

Der Steg 4 weist eine Aufnahmerinne 7 mit rechteckigem Querschnitt auf deren Mittelebene unter einem spitzen Winkel geneigt zur Fläche der Längswand 2 ausgerichtet ist. Der Querschnitt der Aufnahmerinne 7 kann auch eine andere Form mit gekrümmten Seitenwänden haben. Es kommt dann auf die Neigung der Seitenwände an. An dem Steg 3 sitzt eine der Aufnahmerinne 7 entsprechende Leiste 8, die paarig in die Aufnahmerinne 7 paßt.

Eine Stirnplatte 9 zum Abschluß des Gehäuses weist zwei Durchgänge 10 für Schrauben auf, die in die Schraubkanäle 5 eingreifen. Eine gleiche Stirnplatte 9, die nicht dargestellt ist, befindet sich am gegenüberliegenden Ende des Gehäuses.

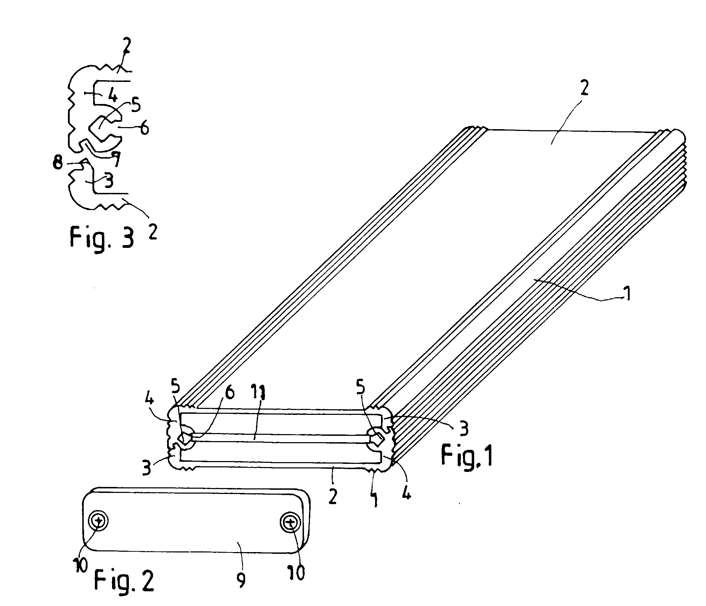

Das Zusammenfügen der Halbschalen 1 ist in Richtung der Mittelebene der Aufnahmerinne 7 und in Ausrichtung der Leiste 8 ohne weiteres möglich, wie Fig. 3 deutlich erkennen läßt. Die Bewegung erfolgt dabei geneigt zur Fläche der Längswand 2. Sobald die Stiniplatte 9 aufgeschraubt ist, sind die Halbschalen festgelegt und das Gehäuse ist gesichert, da die in die Schraubkanäle eingreifenden Schrauben eine Verschiebung der Halbschalen entgegen der Richtung des Zusammenfügens nicht zulassen. Die Ausrichtung der Leiste 8 unter einem spitzen Winkel zur Fläche der Längswand 2 verhindert eine Schwenkung der Halbschale 1 um die Achse einer Schraubverbindung.

## Patentansprüche

1. Gehäuse für elektronische Bauteile mit zwei rinnenförmigen Halbschalen, deren an einer Längsseite sitzende Stege mit einer Aufnahmerinne und einer Leiste paarig zueinander passen und Schraubkanäle aufweisen, und mit einer in die Schraubkanäle der Halbschalen eingreifenden und dieselben zusammenhaltenden Stirnplatte, dadurch gekennzeichnet, daß die Seitenwände der Aufnahmerinne (7) und der Leiste (8) jeweils unter einem spitzen Winkel zu der Längsseite (2) der Halbschalen ausgerichtet sind.

2. Gehäuse nach Anspruch 1, dadurch gekennzeichnet, daß die Neigung der Seitenwände der Aufnahmerinne (7) mindestens 20° beträgt.

3. Gehäuse nach Anspruch 1 oder 2, dadurch gekennzeichnet, daß die Seitenwände der Aufnahmerinne (7) nach der Außenseite des Steges (4) geneigt sind.

4. Gehäuse nach einem der Ansprüche 1 bis 3, dadurch gekennzeichnet, daß die Aufnahmerinne (7) und die Leiste (8) einen rechteckigen Querschnitt haben.
